# EUROPEAN PATENT APPLICATION

(11) **EP 4 333 077 A1**
(43) Date of publication of application: **06.03.2024**
(21) Application number: 22841112.0
(22) Date of filing: 15.06.2022
(51) Int. Cl.: H01L 29/78, H01L 27/02, H01L 29/06, H01L 21/336

(54) **GGNMOS TRANSISTOR STRUCTURE, AND ESD PROTECTION COMPONENT AND CIRCUIT**

(30) Priority: 16.07.2021 CN 202110810592
(71) Applicant: CSMC Technologies Fab2 Co., Ltd., Wuxi New District Wuxi Jiangsu 214028 (CN)
(72) Inventor: HUANG, Lu, Wuxi, Jiangsu 214028 (CN); HUANG, Yong, Wuxi, Jiangsu 214028 (CN); YAN, Yan, Wuxi, Jiangsu 214028 (CN); ZHOU, Wanyi, Wuxi, Jiangsu 214028 (CN); WU, Lin, Wuxi, Jiangsu 214028 (CN); ZHOU, Cheng, Wuxi, Jiangsu 214028 (CN); SHI, Haili, Wuxi, Jiangsu 214028 (CN)
(74) Representative: Dai, Simin
(86) International application number: PCT/CN2022/098844
(87) International publication number: WO 2023/284472

(57) **Abstract**

The present disclosure provides a GGNMOS transistor structure, an ESD protection device, and an ESD protection circuit. The GGNMOS transistor structure can increase a capability of the ESD protection device to discharge an ESD current per unit size under the action of a P-N-P-N parasitic thyristor formed by an N-potential well, a P-type heavily doped region, and an N-type heavily doped region; the GGNMOS transistor structure can limit a transient peak current of ESD under the action of an equivalent resistor formed by an N-potential well, so that respective GGNMOS transistors of the ESD protection device can conduct uniformly, improving the reliability of the ESD protection circuit.

## Description

### CROSS-REFERENCE TO RELATED APPLICATIONS

This application claims priority to Chinese patent application No. 202110810592.3 entitled "GGNMOS transistor structure, ESD protection device and circuit" and filed with the China National Intellectual Property Administration on July 16, 2021, entire contents of which are incorporated herein by reference.

### TECHNICAL FIELD

The present disclosure relates to the technical field of ESD protection design for integrated circuits, and in particular, to a GGNMOS transistor structure, an ESD protection device and circuit.

### BACKGROUND

Electro-Static Discharge (ESD) is a main cause of damage to Electrical Over Stress (EOS) of electronic components or Integrated Circuits (ICs). Since a line width of IC process nodes is developed to a deep submicron stage, a physical size of components is decreasing, but a transient voltage of ESD is very high (usually over several thousand volts), which may cause destructive and permanent damage, and directly lead to circuit burning. Therefore, ESD protection design has become one of important topics in reliability research of ICs.

At present, a common ESD protection device is GGNMOS (Gate-Ground N-Metal-Oxide-Semiconductor). The GGNMOS device mainly uses a parasitic NPN transistor to conduct and discharge an ESD current. The parasitic NPN transistor is composed of a drain electrode, a P-potential well, and a source electrode. The conduction of the parasitic NPN transistor depends on an avalanche breakdown voltage of a reverse PN junction of a collector electrode. The PN junction consists of the drain electrode and the P-potential well. When a GGNMOS transistor is selected as the ESD protection device, a large size needs to be designed to ensure that the discharged ESD current is high enough. In practical applications, due to the limitation of an IC size and the requirement for uniformity of discharged ESD currents, the GGNMOS transistor is usually designed to be of a multi-finger structure, which is equivalent to multiple NMOS structures connected in parallel.

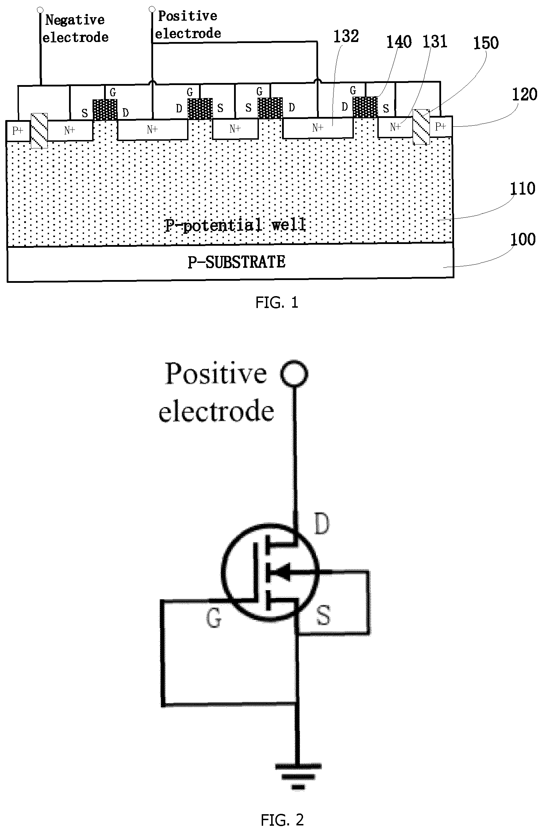

FIG. 1 is a schematic diagram showing an exemplary GGNMOS transistor structure in the prior art. A single-finger GGNMOS transistor structure includes a P-type substrate 100, a P-potential well 110, a P-type heavily doped region 120, a first N-type heavily doped region 131, a gate structure 140, a second N-type heavily doped region 132, and an insulation structure 150, where the insulation structure 150 is arranged between the P-type heavily doped region 120 and the first N-type heavily doped region 131; the gate structure 140 is formed on a channel between the first N-type heavily doped region 131 and the second N-type heavily doped region 132; both the P-type heavily doped region 120 and the first N-type heavily doped region 131 are connected to a negative electrode; the second N-type heavily doped region 132 is connected to a positive electrode; the first N-type heavily doped region 131 is used as a source region, and the second N-type heavily doped region 132 is used as a drain region; the first N-type heavily doped region 131, the second N-type heavily doped region 132, and the P-type substrate 100 there below form a parasitic NPN transistor.

FIG. 2 shows an exemplary ESD protection circuit in the prior art, where a drain electrode of an NMOS transistor is connected to a positive electrode; a source electrode and a gate electrode of the NMOS transistor are connected together, and are connected to a negative electrode; the positive electrode is connected to an input/output end, and the negative electrode is grounded.

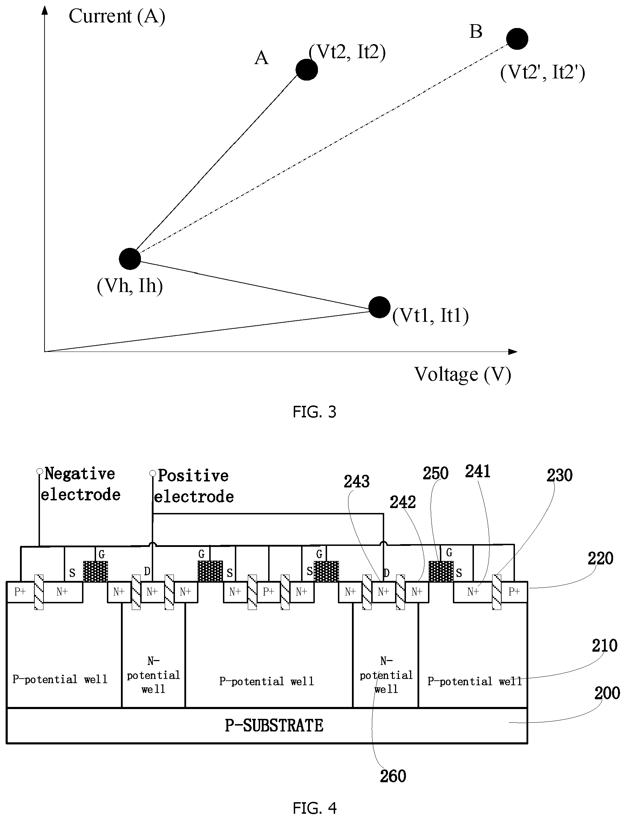

FIG. 3 shows an I-V curve of an exemplary GGNMOS transistor at ESD in the prior art. When a voltage rises to Vt1, a parasitic NPN transistor in the GGNMOS transistor conducts and discharges currents, and at this time a Snap-Back state is immediately entered and the voltage drops to Vh, and as the discharge continues, voltages at both ends of the device increase, reaching a breakdown voltage Vt2 at point A and burning. In addition, ESD currents discharged from respective fingers of the GGNMOS transistor are non-uniform, causing a decrease in an overall circuit ESD protection capability.

In order to optimize a phenomenon of non-uniform ESD currents conducted by the GGNMOS transistor, FIG. 4 is a schematic diagram showing another exemplary GGNMOS transistor structure in the prior art. An improved single-finger GGNMOS transistor structure includes: a P-type substrate 200, a P-potential well 210, an N-potential well 260, a P-type heavily doped region 220, an insulation structure 230, a first N-type heavily doped region 241, a gate structure 250, a second N-type heavily doped region 242, and a third N-type heavily doped region 243, where the insulation structure 230 is arranged between the P-type heavily doped region 220 and the first N-type heavily doped region 241; the gate structure 250 is arranged on an upper surface of the P-potential well 210 between the first N-type heavily doped region 241 and the second N-type heavily doped region 242; the P-type heavily doped region 220 and the first N-type heavily doped region 241 are connected to a negative electrode; the third N-type heavily doped region 243 is connected to a positive electrode; the first N-type heavily doped region 241 is used as a source region; the second N-type heavily doped region 242 and the third N-type heavily doped region 243 are used as a drain region; the N-potential well 260 forms an equivalent resistor.

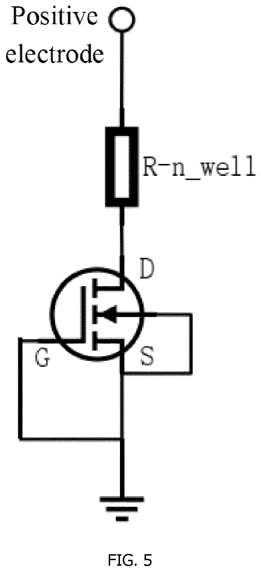

FIG. 5 shows another exemplary ESD protection circuit in the prior art, where a first end of a resistor R-n_well is connected to a positive electrode, and a second end of the resistor R-n_well is connected to a drain electrode of an NMOS transistor; a source electrode and a gate electrode of the NMOS transistor are connected together and are connected to a negative electrode; the positive electrode is connected to an input/output end, and the negative electrode is grounded. Although such ESD protection device of this GGNMOS transistor structure improves the uniformity of ESD currents discharged from respective fingers, a capability for discharging ESD currents of a unit size of respective fingers of the GGNMOS transistor will decrease.

Therefore, there is a need to provide a new GGNMOS transistor structure, an ESD protection device, and an ESD protection circuit to improve the uniformity of discharged ESD currents and increase the capability to discharge ESD currents per unit size.

### SUMMARY

In view of all the above-described deficiencies in the prior art, an objective of the present disclosure is to provide a GGNMOS transistor structure, an ESD protection device, and an ESD protection circuit for solving the problem of non-uniform ESD currents discharged from a multi-finger GGNMOS transistor, while increasing a capability to discharge ESD currents per unit size.

To achieve the above objective and other related objectives, the present disclosure provides a GGNMOS transistor structure, including:
a P-type substrate;
a first N-potential well, a P-potential well, and a second N-potential well that are adjacent and horizontally arranged on the P-type substrate in sequence;
a first P-type heavily doped region arranged above the first N-potential well;
a first N-type heavily doped region arranged above the first N-potential well, where an insulation structure is arranged between the first N-type heavily doped region and the first P-type heavily doped region;
a second P-type heavily doped region arranged above the P-potential well, where an insulation structure is arranged between the second P-type heavily doped region and the first N-type heavily doped region;
a second N-type heavily doped region arranged above the P-potential well, where an insulation structure is arranged between the second N-type heavily doped region and the second P-type heavily doped region;
a third N-type heavily doped region arranged above a boundary between the P-potential well and the second N-potential well;
a fourth N-type heavily doped region arranged above the second N-potential well, where an insulation structure is arranged between the fourth N-type heavily doped region and the third N-type heavily doped region;
a gate structure arranged on an upper surface of the P-potential well between the third N-type heavily doped region and the second N-type heavily doped region,
where the first P-type heavily doped region, the first N-type heavily doped region, and the fourth N-type heavily doped region are connected to a positive electrode, and the second P-type heavily doped region, the second N-type heavily doped region, and the gate structure are connected to a negative electrode.

Specifically, the second N-type heavily doped region is used as a source region; the third N-type heavily doped region and the fourth N-type heavily doped region are used as a drain region.

Specifically, the first N-potential well and the first P-type heavily doped region form an equivalent PNP transistor; the first N-potential well, the first P-type heavily doped region, and the second N-type heavily doped region form an equivalent NPN transistor; the second N-potential well forms an equivalent resistor.

Specifically, upper surfaces of the first P-type heavily doped region, the first N-type heavily doped region, the second P-type heavily doped region, the second N-type heavily doped region, the third N-type heavily doped region, and the fourth N-type heavily doped region are flush.

Specifically, junction depths of the first P-type heavily doped region, the first N-type heavily doped region, the second P-type heavily doped region, the second N-type heavily doped region, the third N-type heavily doped region, and the fourth N-type heavily doped region are same.

Specifically, the positive electrode is connected to an input/output end; the negative electrode is grounded.

The present disclosure further provides an ESD protection device, including: at least two GGNMOS transistor structures as described above, where the GGNMOS transistor structures are connected in parallel.

Specifically, a number of the GGNMOS transistor structures is even.

The present disclosure further provides an ESD protection circuit, including: at least two ESD protection modules, where the ESD protection modules are connected in parallel; each of the ESD protection modules includes: a resistor, an NMOS transistor, a PNP transistor, and a NPN transistor, where,
a first end of the resistor is connected to a positive electrode, and a second end of the resistor is connected to a drain electrode of the NMOS transistor; a gate electrode and a source electrode of the NMOS transistor are connected together, and are connected to a negative electrode;
an emitter electrode of the PNP transistor is connected to the first end of the resistor, a base electrode of the PNP transistor is connected to a collector electrode of the NPN transistor, and a collector electrode of the PNP transistor is connected to a base electrode of the NPN transistor; an emitter electrode of the NPN transistor is connected to the gate electrode and the source electrode of the NMOS transistor.

Further, a positive electrode of the ESD protection module is connected to an input/output end, and a negative electrode of the ESD protection module is grounded.

As described above, the GGNMOS transistor structure, the ESD protection device, and the ESD protection circuit in the present disclosure have the following advantageous effects:

In the GGNMOS transistor structure of the present disclosure, the first N-potential well and the first P-type heavily doped region form an equivalent PNP transistor; the first N-potential well, the first P-type heavily doped region, and the second N-type heavily doped region form an equivalent NPN transistor; the equivalent PNP transistor and the equivalent NPN transistor form a P-N-P-N parasitic thyristor structure. In the GGNMOS transistor structure of the present disclosure, by utilizing characteristics of a small conduction resistance value, a low conduction voltage, and a strong discharge capability per unit size of thyristor, the capability of the ESD protection device to discharge ESD currents perunit size is improved, and the reliability of the ESD protection circuit is enhanced.

The second N-potential well in the GGNMOS transistor structure of the present disclosure forms an equivalent resistor, and the equivalent resistor enables each GGNMOS transistor in the ESD protection device to uniformly conduct and discharge an ESD current, improving the uniformity of the ESD protection circuit.

All of the P-type heavily doped regions and the N-type heavily doped regions in the GGNMOS transistor structure of the present disclosure can be accomplished simultaneously in the process of MOS production, economizing ESD ion implantation photomasks and technological processes, saving costs, reducing process complexity, and decreasing pollution caused in the production process.

### BRIEF DESCRIPTION OF THE DRAWINGS

FIG. 1 is a schematic diagram showing an exemplary GGNMOS transistor structure in the prior art.
FIG. 2 shows an exemplary ESD protection circuit in the prior art.
FIG. 3 shows an I-V curve of an exemplary GGNMOS transistor at ESD in the prior art.
FIG. 4 is a schematic diagram showing another exemplary GGNMOS transistor structure in the prior art.
FIG. 5 shows another exemplary ESD protection circuit in the prior art.
FIG. 6 is a schematic diagram showing a GGNMOS transistor structure according to Embodiment 1 of the present application.
FIG. 7 shows an ESD protection circuit according to Embodiment 3 of the present application.
FIG. 8 shows an I-V curve of an ESD protection device at ESD according to Embodiment 2 of the present application.

Description of reference signs:
300 P-type substrate
311 First N-potential well
312 Second N-potential well
320 P-potential well
331 First P-type heavily doped region
332 Second P-type heavily doped region
341 First N-type heavily doped region
342 Second N-type heavily doped region
343 Third N-type heavily doped region
344 Fourth N-type heavily doped region
350 Insulation structure
360 Gate structure

### DETAILED DESCRIPTION OF THE EMBODIMENTS

Embodiments of the present disclosure will be illustrated below by way of specific examples. Those skilled in the art can easily learn other advantages and effects of the present disclosure from contents disclosed in the specification. The present disclosure may be implemented or applied through other different specific embodiments. Details in the specification can be modified or changed in various ways based on different perspectives and applications without departing from the spirit of the present disclosure.

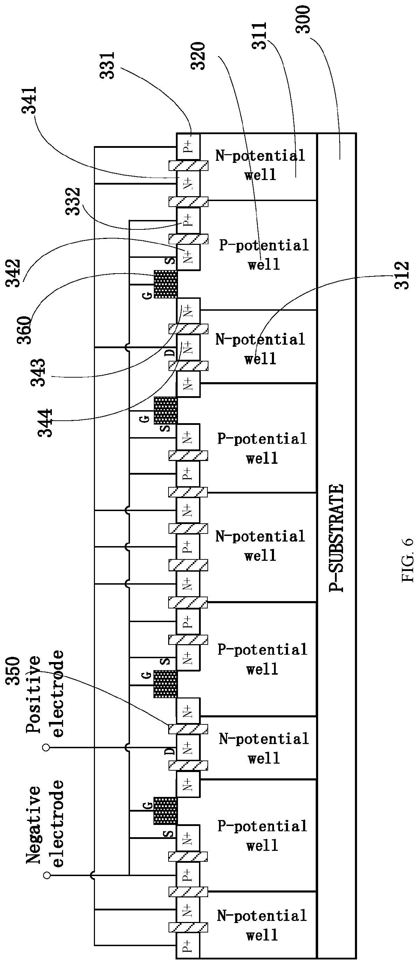

It should be noted that drawings (FIGS. 6 to 8) provided in the embodiments only illustrate a basic concept of the present disclosure in a schematic manner. Therefore, the drawings only show components related to the present disclosure that are not drawn according to actually implemented numbers, shapes and sizes. In the actual implementation, forms, numbers and proportions of the components may be arbitrarily changed, and their layout forms may be more complex.

### Embodiment 1

As shown in FIG. 6, this embodiment provides a GGNMOS transistor structure, including: a P-type substrate 300; a first N-potential well 311, a P-potential well 320, and a second N-potential well 312 that are adjacent and horizontally arranged on the P-type substrate 300 in sequence; a first P-type heavily doped region 331 arranged above the first N-potential well 311; a first N-type heavily doped region 341 arranged above the first N-potential well 311, where an insulation structure 350 is arranged between the first N-type heavily doped region 341 and the first P-type heavily doped region 331; a second P-type heavily doped region 332 arranged above the P-potential well 320, where an insulation structure 350 is arranged between the second P-type heavily doped region 332 and the first N-type heavily doped region 341; a second N-type heavily doped region 342 arranged above the P-potential well 320, where an insulation structure 350 is arranged between the second N-type heavily doped region 342 and the second P-type heavily doped region 332; a third N-type heavily doped region 343 arranged above the P-potential well 320 and the second N-potential well 312; a gate structure 360 formed on a channel between the third N-type heavily doped region 343 and the second N-type heavily doped region 342; a fourth N-type heavily doped region 344 arranged above the second N-potential well 312, where an insulation structure 350 is arranged between the fourth N-type heavily doped region 344 and the third N-type heavily doped region 343,
where all of the first P-type heavily doped region 331, the first N-type heavily doped region 341, and the fourth N-type heavily doped region 344 are connected to a positive electrode, and all of the second P-type heavily doped region 332, the second N-type heavily doped region 342, and the gate structure 360 are connected to a negative electrode.

Specifically, as shown in FIG. 6, the P-type substrate 300 is arranged at a bottom layer. Materials for the P-type substrate 300 include, but are not limited to, sapphire, silicon carbide, silicon, and graphene. Any material that can be used as the substrate is applicable, which will not be elaborated here.

Specifically, as shown in FIG. 6, the first N-potential well 311, the P-potential well 320, and the second N-potential well 312 are arranged on the P-type substrate 300; the P-potential well 320 is between the first N-potential well 311 and the second N-potential well 312; the first N-potential well 311 and the second N-potential well 312 are N-type lightly doped; the P-potential well 320 is P-type lightly doped; doping concentration may be set according to actual needs.

Specifically, as shown in FIG. 6, the first P-type heavily doped region 331 and the first N-type heavily doped region 341 are arranged in the first N-potential well 311; the first P-type heavily doped region 331 and the first N-type heavily doped region 341 are separated through an insulation structure 350, and a depth of the insulation structure 350 is greater than that of the first P-type heavily doped region 331 and the first N-type heavily doped region 341; the second P-type heavily doped region 332 and the second N-type heavily doped region 342 are arranged in the P-potential well 320; the second P-type heavily doped region 332 and the second N-type heavily doped region 342 are separated through an insulation structure 350, and a depth of the insulation structure 350 is greater than that of the second P-type heavily doped region 332 and the second N-type heavily doped region 342; the third N-type heavily doped region 343 is arranged in the P-potential well 320 and the second N-potential well 312; the fourth N-type heavily doped region 344 is arranged in the second N-potential well 312; the third N-type heavily doped region 343 and the fourth N-type heavily doped region 344 are separated through an insulation structure 350, and a depth of the insulation structure 350 is greater than that of the third N-type heavily doped region 343 and the fourth N-type heavily doped region 344. The first P-type heavily doped region 331 and the second P-type heavily doped region 332 are P-type heavily doped; the first N-type heavily doped region 341, the second N-type heavily doped region 342, the third N-type heavily doped region 343, and the fourth N-type heavily doped region 344 are N-type heavily doped; doping concentration may be set according to actual needs, and will not be elaborated here.

Specifically, as shown in FIG. 6, upper surfaces of the first P-type heavily doped region 331, the first N-type heavily doped region 341, the second P-type heavily doped region 332, the second N-type heavily doped region 342, the third N-type heavily doped region 343, and the fourth N-type heavily doped region 344 are flush. However, during production, settings may be made according to actual technology environment conditions, and will not be elaborated here.

Specifically, as shown in FIG. 6, depths of the first P-type heavily doped region 331, the first N-type heavily doped region 341, the second P-type heavily doped region 332, the second N-type heavily doped region 342, the third N-type heavily doped region 343, and the fourth N-type heavily doped region 344 are same. However, during production, settings may be made according to actual technology environment conditions, and will not be elaborated here.

Specifically, as shown in FIG. 6, the second N-type heavily doped region 342 is used as a source region; the third N-type heavily doped region 343 and the fourth N-type heavily doped region 344 are used as a drain region; the source region, the drain region, and the gate structure 360 form a GGNMOS transistor; the source region, the third N-type heavily doped region 343, and the P-potential well 320 form a parasitic NPN transistor.

Specifically, as shown in FIG. 6, the first P-type heavily doped region 331 and the first N-potential well 311 form an equivalent PNP transistor; the first N-potential well 311, the first P-type heavily doped region 331, and the second N-type heavily doped region 342 form an equivalent NPN transistor; the equivalent PNP transistor and the equivalent NPN transistor form a P-N-P-N parasitic thyristor structure; the second N-potential well 312 forms an equivalent resistor.

### Embodiment 2

This embodiment provides an ESD protection device, including at least two GGNMOS transistor structures according to Embodiment 1. The GGNMOS transistor structures are shown in FIG. 6, and the GGNMOS transistor structures are connected in parallel. From the perspective of semiconductor device structure, at least two GGNMOS transistor structures according to Embodiment 1 are referred to as the ESD protection device.

Specifically, the GGNMOS transistor structures are shown in Embodiment 1, and will not be elaborated here. Positive electrodes of GGNMOS transistor structures are connected together, and negative electrodes of the GGNMOS transistor structures are connected together, to achieve a parallel structure. As an example, the positive electrodes of the GGNMOS transistor structures are connected to an input/output end, and the negative electrodes of the GGNMOS transistor structures are grounded. When an ESD forward pulse is added to a GGNMOS transistor, an ESD current flows from a positive electrode to a drain electrode of the GGNMOS transistor, pulling up a voltage of the drain electrode. When the voltage rises to an avalanche breakdown voltage of a parasitic NPN transistor in the GGNMOS transistor, the parasitic NPN transistor is conducted, and discharges the ESD current. In the prior art, since a resistance value of an ESD circuit in a middle finger of a multi-finger GGNMOS transistor structure is maximum and higher than that in a peripheral finger of the multi-finger GGNMOS transistor structure, a parasitic NPN transistor in the middle finger will be conducted before that in the peripheral finger, causing that ESD currents conducted in respective fingers are non-uniform, a capability of the multi-finger GGNMOS transistor to discharge ESD currents is reduced, and an overall circuit ESD protection capability is decreased. The ESD protection device in this embodiment, under the action of an equivalent resistor, can limit a transient peak current of ESD, so that parasitic NPN transistors in respective fingers can be uniformly conducted, and uniformly discharge ESD currents. At the same time, under the action of a P-N-P-N parasitic thyristor structure, a capability of the ESD protection device to discharge ESD currents per unit size can be improved by utilizing characteristics of a small conduction resistance value, a low conduction voltage, and a strong discharge capability per unit size of thyristor.

As an example, a number of the GGNMOS transistor structures included in the ESD protection device is even.

It should be noted that, in this embodiment, the ESD protection device includes four parallel GGNMOS transistor structures as shown in FIG. 6. In actual applications, a corresponding number of GGNMOS transistor structures may be selected for parallel connection according to actual requirements for an ESD protection capability, including, but not limited to, 2 fingers, 3 fingers, 5 fingers, 6 fingers, and 8 fingers, which is not limited in this embodiment.

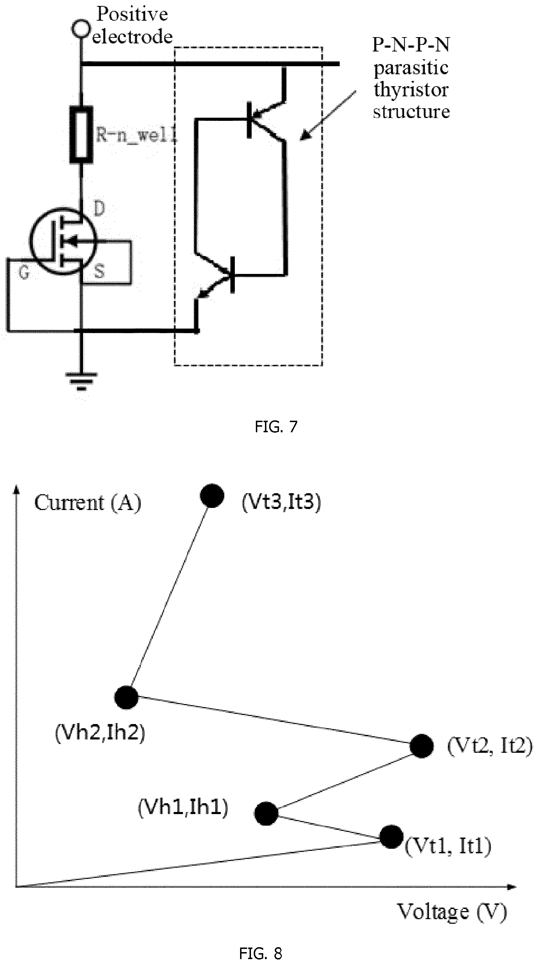

Specifically, FIG. 8 shows an I-V curve of an ESD protection device at ESD in this embodiment. When there is an ESD pulse, a voltage of a GGNMOS transistor first reaches a trigger voltage Vt1, and a parasitic NPN transistor conducts and discharges an ESD current, then rapidly enters a Snap-Back state, so that the voltage drops back to Vh1; due to the effect of an equivalent resistor, a conduction resistance value of an ESD circuit is large, and as the ESD pulse further increases, the discharge continues, so that voltages at both ends of the GGNMOS transistor rise rapidly, and respective fingers of the GGNMOS transistor are conducted uniformly. After the voltage reaches Vt2, a large amount of current flows through the P-potential well 320, causing a potential of the P-potential well 320 to rise rapidly. Under the action of the P-N-P-N parasitic thyristor mentioned in Embodiment 1, most of the ESD current are rapidly discharged from the P-N-P-N parasitic thyristor.

### Embodiment 3

As shown in FIG. 7, this embodiment provides an ESD protection circuit, including: at least two ESD protection modules, where the ESD protection modules are connected in parallel; each of the ESD protection modules includes: a resistor R-n_well, an NMOS transistor, a PNP transistor, and a NPN transistor, where,
a first end of the resistor R-n_well is connected to a positive electrode, and a second end of the resistor R-n_well is connected to a drain electrode of the NMOS transistor; a gate electrode and a source electrode of the NMOS transistor are connected together, and are connected to a negative electrode;
an emitter electrode of the PNP transistor is connected to the first end of the resistor R-n_well, a base electrode of the PNP transistor is connected to a collector electrode of the NPN transistor, and a collector electrode of the PNP transistor is connected to a base electrode of the NPN transistor; an emitter electrode of the NPN transistor is connected to the gate electrode and the source electrode of the NMOS transistor.

Specifically, as an example, the NMOS transistor has a parasitic NPN transistor. For details, reference may be made to Embodiment 2, which will not be elaborated here. In actual applications, any transistor structure is applicable to the present disclosure, and the transistor structure is not limited in this embodiment. From the perspective of electrical circuits, at least two GGNMOS transistor structures according to Embodiment 1 are referred to as the ESD protection modules.

Specifically, as an example, the resistor R-n_well is used to improve the uniformity of conduction by the parasitic NPN transistor. In actual applications, any resistor structure is applicable to the present disclosure, and the resistor structure is not limited in this embodiment.

Specifically, as an example, a positive electrode of the ESD protection circuit in this embodiment is connected to an input/output end, and a negative electrode of the ESD protection circuit is grounded.

Specifically, as an example, the PNP transistor and the NPN transistor form a P-N-P-N parasitic thyristor structure. In actual applications, any thyristor structure is applicable to the present disclosure, and the thyristor structure is not limited in this embodiment.

Specifically, when an ESD forward pulse is added to the ESD protection circuit in this embodiment, under the joint action of the resistor R-n_well and the P-N-P-N parasitic thyristor structure, an ESD current is uniformly discharged, and a capability to discharge the ESD current per unit size is enhanced.

To sum up, the present disclosure provides a GGNMOS transistor structure, an ESD protection device, and an ESD protection circuit, where the GGNMOS transistor structure includes: a P-type substrate; a first N-potential well, a P-potential well, and a second N-potential well that are adjacent and horizontally arranged on the P-type substrate in sequence; a first P-type heavily doped region arranged above the first N-potential well; a first N-type heavily doped region arranged above the first N-potential well, where an insulation structure is arranged between the first N-type heavily doped region and the first P-type heavily doped region; a second P-type heavily doped region arranged above the P-potential well, where an insulation structure is arranged between the second P-type heavily doped region and the first N-type heavily doped region; a second N-type heavily doped region arranged above the P-potential well, where an insulation structure is arranged between the second N-type heavily doped region and the second P-type heavily doped region; a third N-type heavily doped region arranged above a boundary between the P-potential well and the second N-potential well; a fourth N-type heavily doped region arranged above the second N-potential well, where an insulation structure is arranged between the fourth N-type heavily doped region and the third N-type heavily doped region; a gate structure arranged on an upper surface of the P-potential well between the third N-type heavily doped region and the second N-type heavily doped region, where the first P-type heavily doped region, the first N-type heavily doped region, and the fourth N-type heavily doped region are connected to a positive electrode, and the second P-type heavily doped region, the second N-type heavily doped region, and the gate structure are connected to a negative electrode. In the GGNMOS transistor structure of the present disclosure, by utilizing characteristics of a small conduction resistance value, a low conduction voltage, and a strong discharge capability *per* unit size of thyristor, the capability of the ESD protection device to discharge ESD currents per unit size is improved, and the reliability of the ESD protection circuit is enhanced. The second N-potential well in the GGNMOS transistor structure of the present disclosure forms an equivalent resistor, and the equivalent resistor enables each GGNMOS transistor in the ESD protection device to uniformly conduct and discharge an ESD current, improving the uniformity of the ESD protection circuit. All of the P-type heavily doped regions and the N-type heavily doped regions in the GGNMOS transistor structure of the present disclosure can be accomplished simultaneously in the process of MOS production, economizing ESD ion implantation photomasks and technological processes, saving costs, reducing process complexity, and decreasing pollution caused in the production process. Therefore, the present disclosure effectively overcomes various shortcomings in the prior art, and has a high industrial utilization value.

The above embodiments only illustratively explain the principle and effects of the present disclosure, but are not intended to limit the present disclosure. Any person who is familiar with the technology may modify or change the embodiments without violating the spirit and scope of the present disclosure. Therefore, all equivalent modifications or changes made by those with ordinary knowledge in the technical field without departing from the spirit and technical ideas disclosed in the present disclosure shall still be covered by the claims of the present disclosure.

## Claims

1. A GGNMOS transistor structure, comprising at least:
a P-type substrate;
a first N-potential well, a P-potential well, and a second N-potential well that are adjacent and horizontally arranged on the P-type substrate in sequence;
a first P-type heavily doped region arranged above the first N-potential well;
a first N-type heavily doped region arranged above the first N-potential well, wherein an insulation structure is arranged between the first N-type heavily doped region and the first P-type heavily doped region;
a second P-type heavily doped region arranged above the P-potential well, wherein an insulation structure is arranged between the second P-type heavily doped region and the first N-type heavily doped region;
a second N-type heavily doped region arranged above the P-potential well, wherein an insulation structure is arranged between the second N-type heavily doped region and the second P-type heavily doped region;
a third N-type heavily doped region arranged above a boundary between the P-potential well and the second N-potential well;
a fourth N-type heavily doped region arranged above the second N-potential well, wherein an insulation structure is arranged between the fourth N-type heavily doped region and the third N-type heavily doped region;
a gate structure arranged on an upper surface of the P-potential well between the third N-type heavily doped region and the second N-type heavily doped region,
wherein the first P-type heavily doped region, the first N-type heavily doped region, and the fourth N-type heavily doped region are connected to a positive electrode, and the second P-type heavily doped region, the second N-type heavily doped region, and the gate structure are connected to a negative electrode.

2. The GGNMOS transistor structure according to claim 1, wherein the second N-type heavily doped region is used as a source region; the third N-type heavily doped region and the fourth N-type heavily doped region are used as a drain region.

3. The GGNMOS transistor structure according to claim 1, wherein the first N-potential well and the first P-type heavily doped region form an equivalent PNP transistor; the first N-potential well, the first P-type heavily doped region, and the second N-type heavily doped region form an equivalent NPN transistor; the second N-potential well forms an equivalent resistor.

4. The GGNMOS transistor structure according to claim 3, wherein the equivalent PNP transistor and the equivalent NPN transistor form a P-N-P-N parasitic thyristor structure.

5. The GGNMOS transistor structure according to claim 1, wherein upper surfaces of the first P-type heavily doped region, the first N-type heavily doped region, the second P-type heavily doped region, the second N-type heavily doped region, the third N-type heavily doped region, and the fourth N-type heavily doped region are flush.

6. The GGNMOS transistor structure according to claim 1, wherein junction depths of the first P-type heavily doped region, the first N-type heavily doped region, the second P-type heavily doped region, the second N-type heavily doped region, the third N-type heavily doped region, and the fourth N-type heavily doped region are same.

7. The GGNMOS transistor structure according to claim 1, wherein the first N-potential well and the second N-potential well are N-type lightly doped; the P-potential well is P-type lightly doped.

8. The GGNMOS transistor structure according to claim 1, wherein a depth of each insulation structure is greater than that of the first P-type heavily doped region, the first N-type heavily doped region, the second P-type heavily doped region, the second N-type heavily doped region, the third N-type heavily doped region, and the fourth N-type heavily doped region.

9. The GGNMOS transistor structure according to claim 1, wherein the positive electrode is connected to an input/output end; the negative electrode is grounded.

10. An ESD protection device, comprising: at least two GGNMOS transistor structures according to any one of claims 1-6, wherein the GGNMOS transistor structures are connected in parallel.

11. The ESD protection device according to claim 10, wherein a number of the GGNMOS transistor structures is even.

12. An ESD protection circuit, comprising: at least two ESD protection modules, wherein the ESD protection modules are connected in parallel; each of the ESD protection modules comprises: a resistor, an NMOS transistor, a PNP transistor, and a NPN transistor, wherein,
a first end of the resistor is connected to a positive electrode, and a second end of the resistor is connected to a drain electrode of the NMOS transistor; a gate electrode and a source electrode of the NMOS transistor are connected together, and are connected to a negative electrode;
an emitter electrode of the PNP transistor is connected to the first end of the resistor, a base electrode of the PNP transistor is connected to a collector electrode of the NPN transistor, and a collector electrode of the PNP transistor is connected to a base electrode of the NPN transistor; an emitter electrode of the NPN transistor is connected to the gate electrode and the source electrode of the NMOS transistor.

13. The ESD protection circuit according to claim 12, wherein a positive electrode of the ESD protection module is connected to an input/output end, and a negative electrode of the ESD protection module is grounded.
